# EUROPEAN PATENT SPECIFICATION

(11) **EP 2 858 121 B1**
(45) Date of publication and mention of the grant of the patent: **20.12.2017**
(21) Application number: 13798033.0
(22) Date of filing: 03.06.2013
(51) Int. Cl.: H01L 31/042, H01L 31/18, C08J 5/18

(54) **BACKSHEET FOR ECO-FRIENDLY PHOTOVOLTAIC CELL MODULE AND METHOD FOR MANUFACTURING SAME**
RÜCKSEITENFOLIE FÜR UMWELTFREUNDLICHES FOTOVOLTAIKZELLENMODUL UND VERFAHREN ZUR HERSTELLUNG DAVON
FEUILLE ARRIÈRE POUR UN MODULE DE CELLULE PHOTOVOLTAÏQUE RESPECTUEUX DE L'ENVIRONNEMENT ET SON PROCÉDÉ DE FABRICATION

(30) Priority: 01.06.2012 KR 20120059295
(43) Date of publication of application: 08.04.2015
(73) Proprietor: LG Chem, Ltd., Seoul 150-721 (KR)
(72) Inventor: KWON, Yoon Kyung, Daejeon 305-738 (KR); KIM, Hyun Cheol, Daejeon 305-738 (KR)
(74) Representative: Goddar, Heinz J.
(86) International application number: PCT/KR2013/004885
(87) International publication number: WO 2013/180552

(56) References cited:
- EP-A2- 2 410 570
- KR-A- 20040 062 758
- KR-A- 20100 081 795
- KR-A- 20110 118 271
- KR-A- 20110 123 212
- KR-A- 20120 050 381
- US-A1- 2006 280 922

## Description

### TECHINICAL FIELD

The present application relates to an environmentally friendly backsheet for a photovoltaic module and a method of manufacturing the same.

### BACKGROUND ART

Today, attention to clean and renewable forms of energy is increasing due to global environmental problems and the depletion of fossil fuels. Among such forms of energy, solar energy has attracted attention as a representative non-polluting energy source capable of resolving the problems of environmental pollution and depletion of fossil fuels.

A photovoltaic cell is a device that employs a solar power generating principle to convert sunlight into electrical energy. The photovoltaic cell is exposed to an external environment for a long time to facilitate absorption of sunlight. Therefore, photovoltaic cells are formed in a unit called a photovoltaic module by performing various packaging processes to protect the cells.

Generally, the photovoltaic module uses a backsheet having excellent weather resistance and durability to stably protect the photovoltaic cells even when exposed to an external environment for a long time of 20 years or more. Such a backsheet is manufactured by stacking a film having durability and weather resistance on one surface of a substrate.

Generally, as a backsheet for a photovoltaic module, a fluorine-based film having durability and weather resistance is widely used. Conventionally, the fluorine-based film has been processed as a film and attached to a substrate, or dissolved with an organic solvent such as dimethylformamide (DMF), dimethylacetamide (DMAC) or N-methylpyrrolidone (NMP), coated on one surface of a substrate, and subjected to volatilization of the organic solvent, thereby forming a fluororesin layer.

However, the conventional method has problems of a poor adhesive strength to the substrate when the backsheet is processed as a film, and an increase in raw material costs due to use of the organic solvent when the backsheet is processed by coating, which is not environmentally friendly either.

EP 2 410 570 A2 discloses a backsheet for a photovoltaic module, comprising: a resin layer formed by coating a crystalline fluoropolymer on a polyester substrate by an in-line-coating process. The crystallinity of the fluoropolymer is between 10 and 50%. The thickness of the polyester substrate is between 5 to 100 µm.

### SUMMARY OF THE INVENTION

The present application is directed to providing a backsheet for a photovoltaic module which is environmentally friendly and capable of providing excellent physical properties in an orientation process of a substrate, a method of manufacturing the backsheet, and a photovoltaic module including the backsheet.

In one aspect, the present application provides a backsheet for a photovoltaic module comprising a resin layer formed by coating an aqueous dispersion composition including a crystalline fluoropolymer, pigment, an aqueous binder and water on a substrate during orientation of substrate, wherein an adhesive strength measured by a cross-cut test performed according to ASTM D3002/D3359 after the backsheet is left in an oven maintained at 2 atm, 121°C and 100% R.H. for 75 hours is at least 4B.

In another aspect, the present application provides a method of manufacturing a backsheet for a photovoltaic module including forming a resin layer by coating an aqueous dispersion composition including a crystalline fluoropolymer, a pigment, an aqueous dispersion binder and water on one or both surfaces of a substrate in an orientation process of the substrate, and heating the coating result to form a resin layer.

In still another aspect, the present application provides a photovoltaic module including the backsheet for a photovoltaic module.

Further embodiments are disclosed in the sub-claims.

### BRIEF DESCRIPTION OF THE DRAWINGS

FIG. 1 is a cross-sectional view of a backsheet for a photovoltaic module according to an exemplary embodiment of the present application;
FIG. 2 is a cross-sectional view of a photovoltaic module according to an exemplary embodiment of the present application;
FIG. 3 is a cross-sectional view of a photovoltaic module according to another exemplary embodiment of the present application; and
FIG. 4 is a graph of reflectance according to a wavelength according to Examples and Comparative Examples of the present application.

### DETAILED DESCRIPTION OF EXEMPLARY EMBODIMENTS

Hereinafter, exemplary embodiments of the present application will be described in detail. The following embodiments are described in order to enable those of ordinary skill in the related art to embody and practice the present application.

One exemplary embodiment of the present application relates to a backsheet for a photovoltaic module including a resin layer formed by coating an aqueous dispersion composition including a crystalline fluoropolymer, pigment, an aqueous binder and water on a substrate during orientation of the substrate.

A backsheet for a photovoltaic module according to embodiments of the present application may dramatically reduce production costs compared to conventional art. Conventionally, a backsheet for a photovoltaic module was manufactured by laminating a fluoropolymer film on a substrate using an adhesive, or separately coating a fluoropolymer on a substrate using an organic solvent. However, the conventional backsheet had a complicated production process and high expenses due to the manufacture of a separate film and the use of an organic solvent.

However, the present inventor has simplified the entire process by forming a fluororesin layer including a fluoropolymer in a process of manufacturing a substrate using a conventional process of manufacturing a substrate (in-line process), thereby reducing production costs compared to a conventional method of manufacturing a backsheet including forming a separate fluorine layer. For example, the fluororesin layer was formed with the substrate by a biaxial orientation process used in the process of manufacturing the substrate.

The resin layer is formed by coating an aqueous dispersion composition including a crystalline fluoropolymer, a pigment, an aqueous dispersion binder and water on one or both surfaces of a substrate and heating the substrate. The resin layer is a coating layer formed by a coating method, which has a simpler manufacturing process than a method of laminating a film using a separate adhesive, and has excellent interlayer adhesive strength and durability. The resin layer is formed using an in-line coating method in manufacture of a substrate, and is coated on one or both surfaces of the substrate during orientation of the substrate. To manufacture a backsheet for a photovoltaic module according to exemplary embodiments of the present application, the substrate uses a biaxial orientation process. The biaxial orientation process gives orientation by forcibly stretching a non-oriented substrate in a machine direction (MD) and a transverse direction (TD) during an extrusion process. An aqueous dispersion composition including a crystalline fluoropolymer may be coated after uniaxial orientation in a machine direction (MD), coated first and then biaxially oriented in machine and transverse directions (MD and TD), or coated after biaxial orientation.

Adhesion reliability between the substrate and the fluororesin layer can be enhanced by forming the fluororesin layer including a fluoropolymer by an in-line process in the process of manufacturing a substrate. In the backsheet for a photovoltaic module according to exemplary embodiments of the present application, the adhesive strength between the substrate and the fluororesin layer is measured by performing a cross-cut test according to ASTM D3002/D3359 specifications, after the backsheet is left in an oven maintained at 2 atm, 121 °C and 100% R.H. for 25, 50 and 75 hours, and is 4B or more, for example, 5B.

To coat the fluoropolymer on the substrate using the in-line coating process in the manufacture of a substrate, an aqueous dispersion composition is used. When the coating composition includes an organic solvent, danger of explosion or fire may occur during orientation or thermal treatment of the film, and thus the aqueous dispersion composition should be based on water instead of the organic solvent. When the aqueous dispersion composition is used as described above, since the relatively expensive organic solvent is not used, raw material costs may be reduced, and problems of environmental pollution caused by volatilization of the organic solvent and a waste solvent may be reduced, which is environmentally friendly.

The aqueous dispersion composition used to manufacture the fluororesin layer of the backsheet for a photovoltaic module by an in-line coating process in the manufacture of a substrate includes a crystalline fluoropolymer, a pigment, an aqueous dispersion binder and water.

In the aqueous dispersion composition, the fluoropolymer may serve to enhance durability and weather resistance. In embodiments of the present application, when the aqueous dispersion composition is used to form the fluororesin layer, a crystalline fluoropolymer is used instead of a non-crystalline fluoropolymer. This is because, in the non-crystalline fluoropolymer, a urethane bond is formed through a reaction with a curing agent, and provides a good initial adhesive strength, but may be hydrolyzed to break under conditions of high temperature and high humidity, resulting in a lower adhesion reliability than that of the crystalline fluoropolymer.

The crystalline fluoropolymer may have a crystallinity of 55% or less, 50% or less, 10 to 55%, or 10 to 50%. The term crystallinity used herein may refer to a percentage (based on a weight) of a crystalline region included in the entire polymer, and may be measured by a known method such as differential scanning calorimetry.

The fluoropolymer having the above-described crystallinity may be prepared by copolymerizing the above-described comonomer in the manufacture of the fluoropolymer to break a regular atomic array of the fluoropolymer, or to polymerize the fluoropolymer in the type of a branched polymer.

In addition, the fluoropolymer may be a non-functionalized polymer. That is, the aqueous dispersion composition is composed of at least one fluoropolymer, which is not modified by other acrylates. Such a non-functionalized pure fluoropolymer provides advantages of better weather resistance than a fluoropolymer functionalized by an acryl-modified fluoropolymer, a crosslinkable functional group, a carboxyl group, an epoxy group, a hydroxyl group, an acid anhydride group, or an isocyanate group. In the case of the functionalized fluoropolymer, since a polymerizable monomer having a functional group should be added to the fluoropolymer, a ratio of fluorine is reduced, thereby decreasing weather resistance. In addition, since the remaining functional group which is not reacted is destroyed by heat, moisture or UV rays, or hydrolyzed due to decreased stability, yellowing or decrease in adhesive strength will occur in the backsheet.

A kind of the crystalline fluoropolymer may be, for example, a homopolymer, copolymer or mixture thereof including at least one monomer selected from the group consisting of vinylidene fluoride (VDF), vinyl fluoride (VF), tetrafluoroethylene (TFE) hexafluoropropylene (HFP), chlorotrifluoroethylene (CTFE), trifluoroethylene, hexafluoroisobutylene, perfluorobutyl ethylene, perfluoro(methylvinylether) (PMVE), perfluoro(ethylvinylether) (PEVE), perfluoro(propylvinylether) (PPVE), perfluoro(hexylvinylether) (PHVE), perfluoro-2,2-dimethyl-1,3-dioxole (PDD) and perfluoro-2-methylene-4-methyl-1,3-dioxolane (PMD) in a polymerized form. For example, the crystalline fluoropolymer may be a polymer or copolymer including vinylidene fluoride (VDF) in a polymerized form.

In addition, the fluoropolymer may be a copolymer including VDF or VF and a comonomer, and a kind of the comonomer capable of being included in a copolymerized form in the fluoropolymer may be, for example, tetrafluoroethylene (TFE), hexafluoropropylene (HFP), chlorotrifluoroethylene (CTFE), trifluoroethylene, hexafluoroisobutylene, perfluorobutylethylene, perfluoro(methylvinylether) (PMVE), perfluoro(ethylvinylether) (PEVE), perfluoro(propylvinylether) (PPVE), perfluoro(hexylvinylether) (PHVE), perfluoro-2,2-dimethyl-1,3-dioxole (PDD), and perfluoro-2-methylene-4-methyl-1,3-dioxolane (PMD). In one example, the comonomer may be at least one of hexafluoroisobutylene and perfluorobutylethylene.

A content of the comonomer included in the fluoropolymer may be, for example, 0.5 to 50 wt%, 1 to 40 wt%, 7 to 40 wt%, or 10 to 30 wt%. By controlling the content of the comonomer included in the fluoropolymer within the above range, durability and weather resistance may be ensured, and effective low temperature melting may be induced.

A weight average molecular weight of the fluoropolymer may be 50,000 to 1,000,000, 100,000 to 700,000, or 300,000 to 500,000. The weight average molecular weight is a conversion value of standard polystyrene measured by gel permeation chromatography (GPC). As the weight average molecular weight of the fluoropolymer is controlled within the above range, excellent aqueous dispersibility and other physical properties may be ensured.

A melting point of the fluoropolymer may be 80 to 175 °C or 120 to 165 °C. As the melting point of the fluoropolymer is controlled to 80 °C or more, transformation of the backsheet prepared using an aqueous dispersion composition in use can be prevented, and as the melting point of the fluoropolymer is controlled to 175 °C or less, particles of the fluoropolymer are melted at a low temperature and the aqueous dispersion composition is coated on the substrate in the in-line coating process so that a uniformly-coated appearance may be obtained and deterioration of the substrate for the backsheet can be prevented. The fluoropolymer layer may be melted in a pre-heat drying process performed before orientation after a process of coating the aqueous dispersion composition, or in an orientation process. The pre-heat drying process before the orientation process may be performed in a temperature range from approximately 150 to 200 °C.

In addition, the fluoropolymer included in the aqueous dispersion composition may have an average diameter of 50, 10, or 1 µm or less. When the aqueous dispersion composition is coated on the substrate in the in-line coating process, the particles of the fluoropolymer may be disposed on the substrate, and then the particles of the fluoropolymer may be melted by applying heat and changed into a film, thereby forming a resin layer. In this operation, to form a uniform resin layer in this process, the average diameter of the fluoropolymer is preferably 10 µm or less.

A method of preparing the fluoropolymer may employ a means generally used in the related art without limitation. For example, the fluoropolymer may be prepared by emulsion polymerization. When the fluoropolymer is prepared by emulsion polymerization, the average diameter of the fluoropolymer is controlled to 10 µm or less and the fluoropolymer may be formed to a uniform size.

The pigment included in the aqueous dispersion composition may serve to provide a color to the resin layer or enhance other physical properties such as a UV barrier property and reflectance.

The pigment may be included in an amount of 1 to 200 parts by weight with respect to 100 parts by weight of the fluoropolymer. When the content of the pigment is less than 1 part by weight, an effect of adding the pigment may be insignificant, and when the content of the pigment is more than 200 parts by weight, the resin layer formed using the aqueous dispersion composition may be easily broken and scratch resistance may be degraded.

A kind of the pigment capable of being used in exemplary embodiments of the present application may be, for example, a metal oxide such as chromium oxide (Cr₂O₃), iron oxide (Fe₂O₃, Fe₃O₄), titanium dioxide, silica or alumina; a black pigment such as carbon black; a complex metal oxide; a metal salt or various kinds of organic pigments, and preferably titanium dioxide. In addition, barium sulfate, barium titanate (BaTiO₃), strontium titanate (SrTiO₃), calcium titanate (CaTiO₃), calcium carbonate, lead titanate (PbTiO₃), zinc oxide, zinc sulfate, magnesium oxide or aluminum oxide may be used as a white pigment.

In the aqueous dispersion composition, the aqueous dispersion binder serves to reinforce binding between the fluoropolymer and the pigment. When the fluororesin layer is formed using the aqueous dispersion composition, the pigment and the fluoropolymer are fixed, thereby preventing easy detachment of the pigment from a surface of the resin layer, and thus a chalking phenomenon can be prevented.

Examples of the aqueous dispersion binder may include at least one selected from the group consisting of a polyurethane resin, a polyacryl resin, a polyurea resin, a polyamide resin, a polyolefin resin, a polyvinylacetate resin, a polyether resin, an alkyde resin, a urethane-acrylate copolymer, a vinyl-urethane copolymer, an ethylene-vinylalcohol copolymer, a silicon-acryl-urethane copolymer, an ethylene-vinyl acetate copolymer, and an acryl-modified polyester resin, and preferably, an acryl-modified polyester resin.

The aqueous dispersion binder may be included in an amount of 0.1 to 50 parts by weight with respect to 100 parts by weight of the fluoropolymer. As the content of the aqueous dispersion binder is controlled within the above range, weather resistance can be maintained when a fluororesin layer is formed.

In exemplary embodiments of the present application, a crosslinking agent of the aqueous dispersion binder may be further added to the aqueous dispersion composition. As the crosslinking agent of the aqueous dispersion binder, at least one selected from the group consisting of an isocyanate-based resin, an oxazoline-based resin, a melamine-based resin, an epoxy-based resin and a carbodiimide-based resin, and such a crosslinking agent may be linked with the aqueous dispersion binder to control a crosslink density, or may react with a hydroxyl or carboxyl group on a surface of the substrate to further enhance a surface adhesive strength.

The crosslinking agent may be included in an amount of 0.1 to 50 parts by weight with respect to 100 parts by weight of the fluoropolymer. As the content of the aqueous dispersion binder is controlled within the above range, the crosslink density of the aqueous dispersion binder may be suitably controlled, the adhesive strength to the substrate may be further enhanced, and coating properties such as solvent resistance and scratch resistance can be enhanced.

In the aqueous dispersion composition, water is used as a solvent for dispersing the above-described fluoropolymer, pigment and water dispersion binder.

The water may be included in an amount of 100 to 2,000 parts by weight with respect to 100 parts by weight of the fluoropolymer. As the content of the water is controlled within the above range, dispersion stability of the components may be ensured, and a thickness of a resin layer which will be formed using the aqueous dispersion composition may be easily controlled.

In exemplary embodiments of the present application, a surfactant may be further included to enhance dispersibility of the aqueous dispersion composition and wettability with a base when the aqueous dispersion composition is coated on the substrate.

The surfactant may be included at 0.1 to 100 parts by weight, 0.5 to 80 parts by weight, or 1 to 50 parts by weight with respect to 100 parts by weight of the fluoropolymer. When the content of the surfactant is less than 0.1 parts by weight, the dispersibility and wettability may be degraded, and thus uniform coating of the aqueous dispersion composition may be difficult, and when the content of the surfactant is more than 100 parts by weight, the weather resistance may be degraded due to an excessive surfactant.

As an example of the surfactant, a non-ionic surfactant, a cationic surfactant or an anionic surfactant may be used without limitation, but to have excellent compatibility with the fluoropolymer, a fluorine-based surfactant may be used.

The fluorine-based surfactant may be an anionic fluorine-based surfactant such as Zonyl FS-62, Zonyl FSA, Zonyl FSE, Zonyl FSJ, Zonyl FSP, Zonyl TBS or Zonyl UR; a non-ionic fluorine-based surfactant such as Zonyl FSO, Zonyl FSO-100, Zonyl FSN or Zonyl FS-300; a cationic fluorine-based surfactant such as Zonyl FSD; or an anionic and cationic fluorine-based surfactant such as Zonyl FSK or BYK340.

Other than the fluorine-based surfactant, a water-soluble polymer such as polyvinylalcohol, polyvinylpyrrolidone, methyl cellulose, ethyl cellulose or a styrene-maleic anhydride copolymer; an anionic surfactant such as sodium oleate or sodium lauryl sulfate; a non-ionic surfactant such as polyoxyethylene alkylether, polyoxyethylene alkyl phenyl ether, polyoxyethylene fatty acid ester, sorbitan fatty acid ester, polyoxy sorbitan fatty acid ester, polyoxyethylene alkylamine or glycerin fatty acid ester; and a cationic surfactant including a quaternary ammonium such as lauryl amine acetate, an alkyl amine salt or lauryltrimethyl ammonium chloride may be used, or a phosphate such as calcium phosphate, magnesium phosphate, aluminum phosphate or zinc phosphate; a pyrophosphoric acid salt such as calcium pyrophosphorylate, magnesium pyrophosphorylate, aluminum pyrophosphorylate or zinc pyrophosphorylate; or an inorganic dispersing agent such as calcium carbonate, magnesium carbonate, calcium hydroxide, magnesium hydroxide, aluminum hydroxide, calcium meta calcium silicate, calcium sulfate, barium sulfate, colloidal silica or fumed silica may be used.

When the fluoropolymer is polymerized by emulsion polymerization, the fluoropolymer may dispersed in water in advance so that the fluoropolymer prepared by emulsion polymerization may be used without an additional surfactant. Alternatively, when the fluoropolymer prepared by emulsion polymerization is dried and thus in the form of powder, the fluoropolymer may be dispersed by adding the surfactant.

In embodiments of the present application, the aqueous dispersion composition may further include a conventional additive such as a UV stabilizer, a thermal stabilizer or a barrier particle without degrading physical properties.

Since the aqueous dispersion composition does not include an organic solvent, it is economical and environmentally friendly. In addition, as an aqueous dispersion binder is further included, a chalking phenomenon caused by detachment of the pigment can be prevented, and thus economic feasibility and physical properties such as adhesive strength and weather resistance can be enhanced.

In the backsheet for a photovoltaic module according to embodiments of the present application, the crystalline fluoropolymer may be coated on one or both surfaces of the substrate by the in-line coating process. That is, a coating layer of the fluororesin layer is included on one or both surfaces of the substrate.

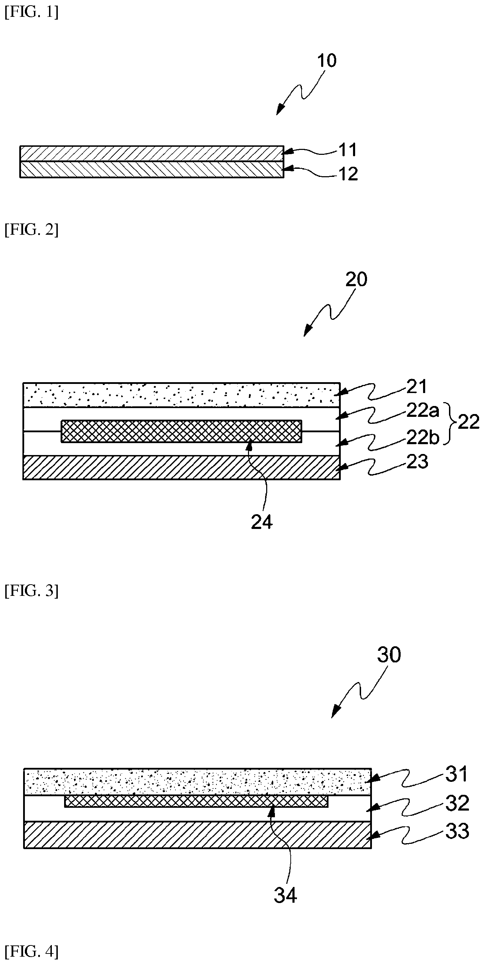

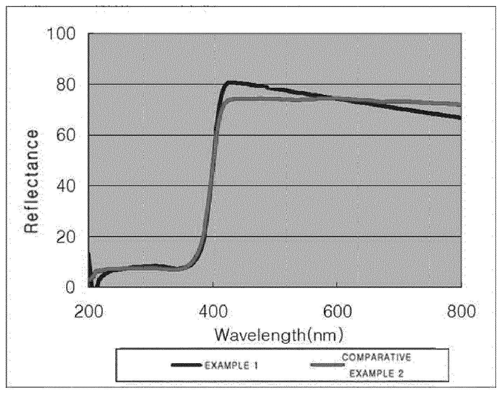

FIG. 1 is a cross-sectional view of a backsheet for a photovoltaic module according to an exemplary embodiment of the present application. As shown in FIG. 1, a backsheet for a photovoltaic module 10 includes a substrate 12; and a fluororesin layer 11 formed on the substrate 12 and including a crystalline fluoropolymer.

In FIG. 1, the backsheet for a photovoltaic module 10 according to one embodiment of the present application includes the substrate 12; and the fluororesin layer 11 only formed on one surface of the substrate 12 and including a crystalline fluoropolymer, but in a backsheet for a photovoltaic module (not shown) according to another embodiment of the present application, a fluororesin layer may also be formed on a surface of a substrate opposite to the above-described surface. As a result, the fluororesin layer may be formed on both surfaces of the substrate.

As a specific kind of the substrate included in the backsheet for a photovoltaic module one of various materials known in the art may be suitably selected according to a required function and its use.

For example, as the substrate, all kinds of polymer film may be used. The polymer film may be at least one selected from the group consisting of an acryl film, a polyolefin film, a polyamide film, a polyurethane film and a polyester film. The polyester film may be at least one selected from the group consisting of a polyethyleneterephthalate (PET) film, a polyethylenenaphthalate (PEN) film and a polybutyleneterephthalate (PBT) film. In addition, a polyester film having an enhanced hydrolysis resistance may be used as needed. The polyester film having an enhanced hydrolysis resistance may include a small content of oligomers generated in condensation polymerization. In addition, the polymer ester film may have a better hydrolysis resistance by further performing known thermal treatment for enhancing hydrolysis resistance to reduce a moisture content in polyester and a contraction rate. Moreover, a commercially available film having excellent hydrolysis resistance may be used.

A thickness of the substrate may be, for example, 50 to 500 µm, or 100 to 300 µm. By controlling the thickness of the substrate within the above range, electric insulability, a moisture barrier property, a mechanical property and handleability may be excellently maintained. However, the thickness of the substrate and may be suitably controlled as needed.

The backsheet for a photovoltaic module includes a resin layer formed on one or both surfaces of the substrate, and the resin layer is formed of the above-described aqueous dispersion composition. That is, the resin layer refers to a coating layer formed of the aqueous dispersion composition, and may also include a melt of the aqueous dispersion composition.

A thickness of the resin layer may be, for example, 0.5 to 30 µm, 1 to 10 µm, or 1 to 5 µm. When the thickness of the resin layer is less than 0.5 µm, the resin layer is too thin and insufficiently filled with the pigment, and thus the photo barrier property may be degraded. When the thickness of the resin layer is more than 30 µm, the resin layer is difficult to manufacture in a conventional in-line coating method.

The resin layer formed of the aqueous dispersion composition may be a coating layer. The term "coating layer" used herein refers to a resin layer formed by a coating method. The "coating layer" refers to the resin layer formed of the above-described aqueous dispersion composition, which is formed by coating the aqueous dispersion composition prepared by dispersing components constituting the resin layer in water on the substrate, not by laminating a sheet manufactured by casting or extrusion on the substrate using an adhesive.

According to exemplary embodiments of the present application, a high-frequency spark discharging treatment such as corona treatment or plasma treatment, thermal treatment, flame treatment, treatment with a coupling agent, treatment with a primer, treatment with an anchoring agent, or chemical activation using gaseous Lewis acid (e.g., BF₃), sulfonic acid, or high-temperature sodium hydroxide may be performed in advance on a surface of the substrate on which the fluororesin layer will be formed to further enhance an adhesive strength.

In addition, to enhance a moisture barrier property, an inorganic oxide depositing layer may be formed on one or both surfaces of the substrate. As a kind of the inorganic oxide any one having a moisture barrier property may be employed without limitation. For example, as the inorganic oxide, a silicon oxide or aluminum oxide may be used. A method of forming the inorganic oxide depositing layer on one or both surfaces of the substrate may be a conventional deposition method generally used in the art. The deposition of the inorganic oxide may be performed at any time, for example, before or after orientation.

When the inorganic oxide depositing layer is formed on one or both surfaces of the substrate after the inorganic oxide depositing layer is formed on a surface of the substrate, the above-described surface treatment may be performed on the inorganic oxide depositing layer.

Another aspect of the present application provides a method of manufacturing the above-described backsheet for a photovoltaic module according to exemplary embodiments of the present application. As described above, the method of the backsheet for a photovoltaic module according to an exemplary embodiment of the present application includes forming a resin layer by coating an aqueous dispersion composition including a crystalline fluoropolymer, a pigment, an aqueous dispersion binder and water on one or both surfaces of a substrate by in-line coating in a process of manufacturing the substrate in an orientation process, and heating the coated result.

The orientation process of the substrate is a biaxial orientation process in which the substrate may be oriented in a machine direction (MD), the aqueous dispersion composition may be coated, and then the substrate may be oriented in a transverse direction (TD). Alternatively, the aqueous dispersion composition may be coated first on the substrate, and then the substrate may be oriented in machine and transverse directions (MD and TD).

The orientation process of the substrate is generally performed after a process of forming a non-oriented film to form a film by cooling a melt-extruded resin on a cast roll to solidify in an extrusion process. Biaxially orienting the non-oriented film in machine and transverse directions (MD and TD) is a biaxial orientation process, in which, for example, the non-oriented film is oriented 2.5 to 5 times of the original size in a machine direction (MD, a vertical direction, that is, a film progressing direction) by a roll heated to 100 to 200 °C, cooled by a roll having a temperature of 50 to 100 °C, and oriented again at both ends of the film 2.5 to 5 times of the original size in a transverse direction (TD, a film width direction), which is perpendicular to the machine direction (MD), at 100 to 200 °C using a roll or tender-type orientation apparatus.

For the biaxial orientation, as described above, a simultaneous biaxial orientation method in which stretching in machine and transverse directions (MD and TD) is simultaneously performed may also be used, in addition to a sequential biaxial orientation method in which stretching in machine and transverse directions (MD and TD) is separately performed.

In the manufacturing method according to exemplary embodiments of the present application, a fluororesin layer is formed in an in-line coating process by including a process of coating the aqueous dispersion composition on the substrate in the biaxial orientation process, and the aqueous dispersion composition is coated on the substrate and heated at 150 to 250 °C to melt a crystalline fluoropolymer of a resin layer, thereby forming a film-type resin layer.

A specific kind of the substrate capable of being used in the manufacturing method is described above, and at least one suitable surface treatment selected from the group consisting of plasma treatment, corona treatment, treatment with a primer, treatment with an anchoring agent, treatment with a coupling agent, deposition treatment and thermal treatment may be performed on one or both surfaces of the substrate before forming the resin layer, or before coating of the aqueous dispersion composition after uniaxial orientation.

As described above, as at least one surface treatment is performed on one or both surfaces of the substrate, a carboxyl group or a hydroxyl group may be introduced to a surface of the substrate. Such functional groups form a chemical bond with a fluoropolymer included in the fluororesin layer and an aqueous dispersion binder to further enhance an interface binding strength between the substrate and the resin layer.

The aqueous dispersion composition may be prepared by dispersing a crystalline fluoropolymer, a pigment and an aqueous dispersion binder in water, dispersing a crystalline fluoropolymer, a pigment, an aqueous dispersion binder and a surfactant in water, or dispersing a crystalline fluoropolymer, a pigment, an aqueous dispersion binder, a surfactant and a conventional additive in water. As the operation of dispersing the various components in water a conventional dispersion method widely used in the art may be used without limitation. As the various components are added to water and then stirred, an aqueous dispersion composition is prepared.

When the aqueous dispersion composition is coated on one surface of the substrate, the crystalline fluoropolymer particles, the pigment and the aqueous dispersion binder are disposed on one surface of the substrate, and when the substrate coated with the aqueous dispersion composition is heated, water is evaporated and the fluoropolymer particles are melted, thereby transforming the substrate in the form of a film. Here, the aqueous dispersion binder may be present in the film of the fluoropolymer to reinforce a bond between the crystalline fluoropolymer and the pigment, and to prevent detachment of the pigment from the surface of the film.

A method of coating the aqueous dispersion composition on a surface of the substrate is any one capable of being applied to the in-line coating method. For example, a method such as roll coating, knife-edge coating, gravure coating or doctor blading may be used.

As a method of heating the substrate coated with the aqueous dispersion composition thermal treatment in a conventional in-line coating method may be used. For example, a process of removing moisture from the substrate coated with the aqueous dispersion composition using an oven or a process of heating the substrate coated through the orientation process may be used.

A temperature for the process of removing moisture from the substrate coated with the aqueous dispersion composition is a melting point of the fluoropolymer or higher, for example, 150 to 250 °C. When the heating temperature is less than 150 °C, the fluoropolymer particles are not dissolved, and thus the film of the fluoropolymer may not be formed, and when the heating temperature is more than 250 °C, the substrate may be deteriorated, and thus the mechanical properties of the substrate may be degraded.

After a thermal fixing process by the above-described thermal treatment, the thermally-fixed orientation film may be relaxed in machine and transverse directions (MD and TD). As the relaxation of the thermally-fixed orientation film in the machine and transverse directions (MD and TD) is further performed, a thermal contraction rate of an edge of the film may be reduced.

A temperature during relaxing may be 150 to 250 °C. As the substrate after biaxial orientation may be thermally fixed at a relatively low temperature followed by relaxing treatment in machine and transverse directions (MD and TD), hydrolysis resistance may be maintained for a long time and dimensional stability of the film may be more effectively maintained without destroying oriented molecules. That is, after the thermal fixing treatment, the substrate may be allowed to contract in a machine direction (MD) in a relaxation rate within 30%, and in a transverse direction in a relaxation rate within 30%.

The term "relaxation rate" indicates a value obtained by dividing a relaxation length by a dimension before orientation.

According to the method of manufacturing a backsheet for a photovoltaic module according to embodiments of the present application, a separate fluoropolymer is not coated on a previously manufactured substrate, but rather a fluoropolymer is coated through an in-line coating process during the manufacture of the substrate, thereby minimizing transformation of the substrate by heat and moisture and enhancing productivity and quality. In addition, since this method does not use an organic solvent, it may be more environmentally friendly, reduce production costs, and have a simple process. As a result, a backsheet for a photovoltaic module which is economical, environmentally friendly and has weather resistance can be manufactured.

Still another aspect of the present application provides a photovoltaic module including the above-described backsheet for a photovoltaic module.

A structure of the photovoltaic module is not particularly limited as long as it includes the backsheet for a photovoltaic module, and thus various structures generally known in the art may be used without limitation. As an example, the structure of the photovoltaic module may include a backsheet, a photovoltaic cell or photovoltaic array formed on the backsheet, a light-receiving sheet formed on the photovoltaic cell or photovoltaic array, and an encapsulant layer for encapsulating the photovoltaic cell or photovoltaic array between the backsheet and the light-receiving sheet.

A thickness of the backsheet is not particularly limited and may be, for example, 30 to 2,000 µm, 50 to 1,000 µm, or 100 to 600 µm. As the thickness of the backsheet is controlled to 30 to 2,000 µm, a thinner photovoltaic module may be formed, and excellent physical properties such as weather resistance of the photovoltaic module may be maintained.

A specific kind of a photovoltaic cell formed on the backsheet is not particularly limited as long as it is capable of generating a photoelectro-motive force, and therefore a photovoltaic device generally used in the related art may be used. For example, a crystalline silicon photovoltaic cell, for example, using monocrystalline silicon or polycrystalline silicon, a single-bonded or tandem-structured amorphous silicon photovoltaic cell, a semiconductor photovoltaic cell including a III-V group compound such as gallium-arsenic (GaAs) or indium-phosphorous (InP), and a semiconductor photovoltaic cell including a II-VI group compound such as cadmium-tellurium (CdTe) or copper-indium-selenide (CuInSe₂) may be used, or a thin film polycrystalline silicon photovoltaic cell, a thin film non-crystalline polycrystalline silicon photovoltaic cell and a hybrid photovoltaic cell of thin film crystalline silicon and amorphous silicon may be used.

The photovoltaic cell may form a photovoltaic array (photovoltaic collector) by interconnections between photovoltaic cells. When sunlight is incident on the photovoltaic module, an electron (-) and a hole (+) are generated in the photovoltaic cell, thereby inducing a current through an interconnection between photovoltaic cells.

The light-receiving sheet formed on the photovoltaic cell or photovoltaic array may protect an inside of the photovoltaic module from wind and rain, external impact or fire, and may serve to ensure long-term reliability when the photovoltaic module is exposed to an external environment. A specific kind of the light-receiving sheet is not particularly limited as long as it has excellent light transmittance, electrical insulation, and mechanical, physical or chemical strength. For example, the light-receiving sheet may be a glass plate, a fluororesin sheet, a cyclic polyolefin-based resin sheet, a polycarbonate-based resin sheet, a poly(meth)acryl-based resin sheet, a polyamide-based resin sheet or a polyester-based resin sheet. In one exemplary embodiment of the present application, a glass plate having excellent thermal resistance may be used.

The light-receiving sheet may have a thickness of, for example, 0.5 to 10 mm, 1 to 8 mm, or 2 to 5 mm. As the thickness of the light-receiving substrate is controlled within a range of 0.5 to 10 mm, a thinner photovoltaic module may be formed, and excellent physical properties such as long-term reliability of the photovoltaic module may be maintained.

In addition, the encapsulant layer for encapsulating a photovoltaic cell or photovoltaic array in the photovoltaic module, particularly, between the backsheet and the light-receiving sheet, may employ an encapsulant generally known in the related art without limitation.

FIGS. 2 and 3 are cross-sectional views of photovoltaic modules according to various exemplary embodiments of the present application.

FIG. 2 illustrates an example of a wafer-based photovoltaic module 20 including a backsheet for a photovoltaic module according to an exemplary embodiment of the present application. As shown in FIG. 3, the photovoltaic module according to an exemplary embodiment of the present application may include a light-receiving sheet 21 which may be formed of a conventional ferroelectric material (e.g., glass); a backsheet for a photovoltaic module 23 according to an exemplary embodiment of the present application; a photovoltaic device 24 of the silicon-based wafer; and an encapsulant layer 22 encapsulating the photovoltaic device 24. Here, the encapsulant layer 22 may include a first layer 22a encapsulating the photovoltaic device 24 and adhered to the light-receiving sheet 21, and a second layer 22b encapsulating the photovoltaic device 24 and adhered to the backsheet 23. The first and second layers constituting the encapsulant layer 22 may be formed of a material generally known in the related art as described above.

FIG 3 is a cross-sectional view of a thin film-type photovoltaic module 30 according to another exemplary embodiment of the present application. As shown in FIG 3, in the thin film-type photovoltaic module 30, a photovoltaic device 34 may be formed on a light-receiving sheet 31 that can be generally formed of ferroelectric material. The thin film-type photovoltaic device 34 may be deposited by conventional chemical vapor deposition (CVD). The photovoltaic module 30 in FIG. 3 may include a backsheet 33, an encapsulant layer 32, the photovoltaic device 34 and the light-receiving sheet 31, similar to the photovoltaic module 20 of FIG 2, and the encapsulant layer 32 may be formed as a single layer. Details about the encapsulant layer 32 and the backsheet 33 are described above.

The method of preparing a photovoltaic module may employ various methods known to those of ordinary skill in the related art without particular limitation.

The photovoltaic modules shown in FIGS. 2 and 3 are only examples of various exemplary embodiments of the photovoltaic modules of the present application. In the case of a backsheet for a photovoltaic module according to the present application, a structure of the module and a kind and a size of a material constituting the module may be based on the related art without limitation.

### [Examples]

Hereinafter, the present application will be described in detail with reference to Examples according to the present application and Comparative Examples not according to the present application.

### Example 1

### Preparation of aqueous dispersion composition

20 g of an acryl-modified polyester resin in the form of an aqueous dispersion of a copolymer of polyethyleneterephthalate (PET), glycidylmethacrylate (GMA), methylmethacrylate (MMA) and methylmethacrylic acid (MAA), molar ratio = 1: 0.5: 0.2, Na+ used as a counter ion of MAA in aqueous dispersing, solid content: 30%) as an aqueous dispersion binder, 5 g of an oxazoline group-containing acrylic copolymer (WS-500, solid content: 40%, Nippon Shokubai Co., Ltd.) as a crosslinking agent and 50 g of titanium dioxide (Tipure TS6200, Dupont) as a pigment were added to 500 g of a polyvinylidenefluoride resin (solid content: 20%) dispersed in water as an emulsion, and dispersed using a stirrer, thereby preparing an aqueous dispersion composition.

### Preparation of backsheet for photovoltaic module

A non-oriented polyethyleneterephthalate film having a thickness of 2500 µm was obtained using a T-die from polyethyleneterephthalate which was melt-extruded after a sufficiently dried polyethyleneterephthalate chip was injected into a melt extruder, and oriented 3.5 times the original size in a machine direction (MD) at 100 °C, thereby manufacturing a uniaxially oriented polyester film. Corona discharging treatment was performed on the manufactured uniaxially oriented polyester film, a previously prepared aqueous dispersion composition was coated thereon using a Meyer bar to have a thickness of 16 µm, dried at 180 °C, and oriented 3.5 times the original size in a transverse direction, thereby manufacturing a biaxially oriented polyester film. Afterward, the biaxially oriented polyester film was thermally treated at 240 °C for 10 seconds and relaxed 10% in machine and transverse directions (MD and TD) at 200 °C, thereby manufacturing a backsheet for a photovoltaic module having a thickness of 300 µm, which was coated with a 2 µm thick resin layer including a fluoropolymer.

### Example 2

A backsheet for a photovoltaic module was manufactured as described in Example 1, except that 5 g of hexamethoxymelamine (Cyme1301, CYTEC) was used as a crosslinking agent instead of the oxazoline group-containing acrylic copolymer used in the manufacture of the aqueous dispersion composition in Example 1.

### Example 3

A backsheet for a photovoltaic module was manufactured as described in Example 1, except that 5 g of an epoxy resin (Denacol EX614B, Nagase Comtex) was used as a crosslinking agent instead of the oxazoline group-containing acrylic copolymer used in the manufacture of the aqueous dispersion composition in Example 1.

### Example 4

A backsheet for a photovoltaic module was manufactured as described in Example 1, except that 5 g of carbodiimide (Carbodilite V02-L2, Nisshinbo chemical Co., Ltd) was used as a crosslinking agent instead of the oxazoline group-containing acrylic copolymer used in the manufacture of the aqueous dispersion composition in Example 1.

### Example 5

A backsheet for a photovoltaic module was manufactured as described in Example 1, except that the oxazoline group-containing acrylic copolymer was not used as a crosslinking agent in the manufacture of the aqueous dispersion composition in Example 1.

### Example 6

A backsheet for a photovoltaic module was manufactured as described in Example 1, except that an acrylic resin (a copolymer of acrylonitrile (AN), methyl methacrylate (MMA), styrene (ST), butyl acrylate (BA) and α-methyl styrene (AMST), weight ratio= 15:5:28:50:2) was used instead of the acryl-modified polyester resin used as an aqueous dispersion binder in Example 1.

### Example 7

A backsheet for a photovoltaic module was manufactured as described in Example 1, except that a urethane resin (Takelac WS-5300, Mitsui chemicals Co., Ltd) was used instead of the acryl-modified polyester resin used as an aqueous dispersion binder in Example 1.

### Example 8

A backsheet for a photovoltaic module was manufactured as described in Example 1, except that a silicon-based urethane resin (Takelac WS-5000, Mitsui chemicals Co., Ltd) was used instead of the acryl-modified polyester resin used as an aqueous dispersion binder in Example 1.

### Example 9

A backsheet for a photovoltaic module was manufactured as described in Example 1, except that a copolymer including vinylidene fluoride (VDF) and hexafluoropropylene (HFP) in a weight ratio of 85:15 (VDF:HFP) in a polymerized form having a crystallinity of 22% was used instead of the polyvinylidenefluoride resin dispersed in water as an emulsion used as an aqueous dispersion composition in Example 1.

### Example 10

A backsheet for a photovoltaic module was manufactured as described in Example 1, except that a copolymer including vinylidene fluoride (VDF) and chlorotrifluoroethylene (CTFE) in a weight ratio of 85:15 (VDF:CTFE) in a polymerized form having a crystallinity of 25% was used instead of the polyvinylidenefluoride resin dispersed in water as an emulsion used as an aqueous dispersion composition in Example 1.

### Comparative Example 1

A coating solution for forming a fluororesin layer was manufactured by adding 25.1 parts by weight of isoporon diisocyanate (equivalent ratio of OH in Zeffle GK-570 to NCO of the crosslinking agent = 1:1) as a crosslinking agent and 60 parts by weight of titanium dioxide (TiPure TS6200, Dupont) as a pigment to 100 parts by weight of a copolymer of tetrafluoroethylene (TFE) and hydroxyl group-substituted ethylene, which is Zeffle GK-570 (Daikin Industries, solid content 60%, 60mgKOH/g) as a heat-curable fluororesin, further adding 10 parts by weight of methylethylketone thereto, and sufficiently stirring the resulting mixture instead of the aqueous dispersion composition in Example 1.

The coating solution for forming a fluororesin layer was coated on one surface of a previously prepared substrate by a comma reverse method. Particularly, the coating solution was coated by controlling a gap to have a thickness of approximately 10 µm after drying, and the coated substrate sequentially passed through three ovens having a length of 2 m, in which temperatures were controlled to 80, 180 and 180 °C, respectively, at a speed of 1 m/min, thereby forming a fluororesin layer. Afterward, the substrate on which the fluororesin layer was stacked was aged at room temperature for 1 week, thereby manufacturing a multilayer film in which one surface of the substrate (PET film) was coated with the fluororesin layer.

### Comparative Example 2

A commercially available stacked structure of a Tedlar film/adhesive/PET film/adhesive/Tedlar film was used as a multilayer film. The stacked structure was a product formed by laminating a Tedlar film (PVF film, thickness: 38 µm) produced by Dupont on both surfaces of a PET film using an adhesive by an extrusion process.

### Comparative Example 3

A backsheet for a photovoltaic module was manufactured as described in Example 1, except that 500 g of an emulsion-type acryl-modified fluoropolymer (solid content: 20%) functionalized by a hydroxyl group to be described below was used instead of the polyvinylidenefluoride resin dispersed in water as an emulsion used in the manufacture of the aqueous dispersion composition in Example 1.

### Preparation of acryl-modified fluoropolymer functionalized by hydroxyl group

An acryl-modified fluoropolymer functionalized by a hydroxyl group was prepared by adding 5 g of 15% ammonium perfluorooctanoate solution to 400 g of distilled water in an 1 L high pressure reaction vessel, adding 70 g of vinylidenefluoride (VDF) and 30 g of 2-hydroxyethyl methacrylate (2-HEMA), and adding 1 g of a 0.5% potassium persulate solution while a temperature of the reaction vessel was maintained at 80 °C.

Physical properties of the backsheets for a photovoltaic module manufactured in Examples and Comparative Examples were measured by the following methods.

### Experimental Example 1: Measurement of Cross-Hatch Adhesive Strength

A cross-cut test was performed according to ASTM D3002/D3359 specifications. Specifically, a specimen was cut horizontally and vertically into 11 rows and columns at intervals of 1 mm using a knife to create a grid of 100 squares each having a size of 1 mm x 1 mm (length x width). Afterward, a CT-24 adhesive tape produced by Nichiban was attached to the gridded surface and then detached to measure a state of the surface detached along with the tape, and the measurement results were evaluated according to the following criteria.

### <Criteria for Evaluating Cross-Hatch adhesive Strength>

5B: there was no detached region
4B: area of detached region was less than 5% of total area
3B: area of detached region was 5 to 15% of total area
2B: area of detached region was 15 to 35% of total area
1B: area of detached region was 35 to 65% of total area
0B: area of detached region was more than 65% of total area

### Experimental Example 2: Pressure Cooker Test (PCT)

The change in adhesive strength was observed by the same method used to measure cross-hatch adhesive strength after each of the backsheets for a photovoltaic module prepared in Examples and Comparative Examples in which both surfaces of a base were coated with a fluoropolymer was left in an oven maintained at 2 atm, 121 °C and 100% R.H. for 25, 50 and 75 hours.

Measurement Results for the physical properties of the backsheets for a photovoltaic module manufactured in Examples and Comparative Examples are shown in Table 1.

**[Table 1]**

| Category | Thickness of fluororesin layer (*µ*m) | **Adhesive strength** | | | |
|---|---|---|---|---|---|
| | | PCT 0 hour | PCT after 25 hours | PCT after 50 hours | PCT after 75 hours |
| Example 1 | 2 | 5B | 5B | 5B | 5B |
| Example 2 | 2 | 5B | 5B | 5B | 5B |
| Example 3 | 2 | 5B | 5B | 5B | 5B |
| Example 4 | 2 | 5B | 5B | 5B | 5B |
| Example 5 | 2 | 5B | 5B | 5B | 5B |
| Example 6 | 2 | 5B | 5B | 5B | 5B |
| Example 7 | 2 | 5B | 5B | 5B | 5B |
| Example 8 | 2 | 5B | 5B | 5B | 5B |
| Example 9 | 2 | 5B | 5B | 5B | 5B |
| Example 10 | 2 | 5B | 5B | 5B | 5B |
| Comparative Example 1 | 10 | 5B | 5B | 1B | 0B |
| Comparative Example 2 | 38 | 5B | 5B | 5B | 1B |
| Comparative Example 3 | 2 | 5B | 5B | 3B | 1B |

As shown in Table 2, it can be confirmed that all of Examples 1 to 8 exhibited excellent adhesive strength.

Meanwhile, it can be confirmed that Comparative Examples 1 to 3 were degraded in adhesive property under harsh conditions. In addition, it can be confirmed that, in Comparative Example 1 using a heat-curable fluorine resin, an organic solvent was used, and thus the backsheet could not be applied in an in-line coating process during manufacture of a polyester film, thereby performing an offline coating process, and the process was more complicated than those described in Examples 1 to 8.

That is, when a backsheet for a photovoltaic module was manufactured using a process of biaxially orienting a polyester film from an aqueous dispersion composition including a fluoropolymer, a pigment, an aqueous dispersion binder and water, a manufacturing process can be simpler than the case of using a conventional lamination process, physical properties such as durability and weather resistance may be excellently maintained, and the process is environmentally friendly and economical since it does not use an organic solvent.

### 3. Experimental Example 3: Measurement of reflectance

Reflectances of the backsheets for a photovoltaic module manufactured in Example 1 and Comparative Example 2 in a wavelength range of 200 to 800 nm were measured using a Shimadzu UV Vis spectrometer (UV-3600), and measurement results are shown in FIG. 4.

As shown in the UV spectrum in FIG. 4, though a thickness of the fluorine-based resin layer was 2 µm, which is thinner than a commercially available backsheet manufactured by a conventional lamination process, it can be confirmed that the backsheet according to the present application exhibited a reflectance at the same level as the conventional backsheet.

A backsheet for a photovoltaic module according to embodiments of the present application can have a resin layer including a fluoropolymer by coating an aqueous dispersion composition including a crystalline fluoropolymer, a pigment, an aqueous dispersion binder and water on a substrate by an in-line coating process. Accordingly, a process of manufacturing the backsheet is simple, economical, and environmentally friendly since the process does not need a toxic organic solvent. In addition, according to the process, risk of explosion or fire in orientation and thermal treatment can be reduced, and both productivity and product quality can be enhanced.

## Claims

1. A backsheet for a photovoltaic module, comprising:
a resin layer formed by coating an aqueous dispersion composition including a crystalline fluoropolymer, pigment, an aqueous binder and water on a substrate during orientation of substrate,
wherein an adhesive strength measured by a cross-cut test performed according to ASTM D3002/D3359 after
the backsheet is left in an oven maintained at 2 atm, 121 °C and 100% R.H. for 75 hours is at least 4B.

2. The backsheet according to claim 1, wherein the fluoropolymer is a crystalline polymer having a crystallinity of 10 to 55% and non-functionality.

3. The backsheet according to claim 1, wherein the fluoropolymer is a homopolymer, copolymer, or mixture thereof including at least one monomer selected from the group consisting of vinylidene fluoride (VDF), vinyl fluoride (VF), tetrafluoroethylene (TFE), hexafluoropropylene (HFP), chlorotrifluoroethylene (CTFE), trifluoroethylene, hexafluoroisobutylene, perfluorobutylethylene, perfluoro(methylvinylether) (PMVE), perfluo-ro(ethylvinylether) (PEVE), perfluoro(propylvinylether) (PPVE), perfluoro(hexylvinylether) (PHVE), perfluoro-2,2-dimethyl-1,3-dioxole (PDD), and perfluoro-2-methylene-4-methyl-1,3-dioxolane (PMD) in a polymerized form.

4. The backsheet according to claim 1, wherein the aqueous dispersion binder is at least one selected from the group consisting of a polyurethane resin, a polyacryl resin, a polyurea resin, a polyamide resin, a polyolefin resin, a polyvinylacetate resin, a polyether resin, an alkyde resin, a urethane-acrylate copolymer, a vinyl-urethane copolymer, an ethylene-vinylalcohol copolymer, a silicon-acryl-urethane copolymer, an ethylene-vinylacetate copolymer, and an acryl-modified polyester resin.

5. The backsheet according to claim 1, wherein the aqueous dispersion binder is included in an amount of 0.1 to 50 parts by weight with respect to 100 parts by weight of the fluoropolymer.

6. The backsheet according to claim 1, wherein the aqueous dispersion composition further includes a crosslinking agent of the aqueous dispersion binder.

7. The backsheet according to claim 6, wherein the crosslinking agent is included in an amount of 0.1 to 50 parts by weight with respect to 100 parts by weight of the fluoropolymer.

8. The backsheet according to claim 1, wherein the resin layer is formed on one or both surfaces of the substrate.

9. The backsheet according to claim 1, wherein the substrate is at least one polymer film selected from the group consisting of an acryl film, a polyolefin film, a polyamide film, a polyurethane film, and a polyester film.

10. The backsheet according to claim 1, wherein the substrate has a thickness of 50 to 500 µm.

11. A method of manufacturing a backsheet for a photovoltaic module, comprising:
forming a resin layer by coating an aqueous dispersion composition including a crystalline fluoropolymer, a pigment, an aqueous dispersion binder and water on one or both surfaces of a substrate and heating in an orientation process of the substrate,

12. The method according to claim 11, wherein the orientation process of the substrate is a biaxial orientation process, in which the substrate is oriented in a machine direction (MD), then coated with the aqueous dispersion composition, and then oriented in a transverse direction (TD).

13. The method according to claim 11, wherein the orientation process of the substrate is a biaxial orientation process, in which the aqueous dispersion composition is coated on the substrate, and then the substrate is oriented in machine and transverse directions (MD and TD).

14. A photovoltaic module, comprising:
the backsheet for a photovoltaic module according to any one of claims 1 to 10.

## Patentansprüche

1. Rückseitiger Bogen für ein Photovoltaikmodul, umfassend:
eine Harzschicht, gebildet durch Beschichten einer wässrigen Dispersionszusammensetzung einschließend ein kristallines Fluorpolymer, Pigment, ein wässriges Bindemittel und Wasser auf einem Substrat während einer Ausrichtung des Substrats,
wobei eine Haftfestigkeit, gemessen durch einen Querschnittstest, durchgeführt gemäß ASTM D3002/D3359, nachdem der rückseitige Bogen in einem Ofen belassen wird, gehalten bei 2 atm, 121°C und 100% relativer Feuchtigkeit für 75 Stunden, wenigstens 4B ist.

2. Rückseitiger Bogen nach Anspruch 1, wobei das Fluorpolymer ein kristallines Polymer mit einer Kristallinität von 10 bis 55% und Nicht-Funktionalität ist.

3. Rückseitiger Bogen nach Anspruch 1, wobei das Fluorpolymer ein Homopolymer, Copolymer oder eine Mischung derselben ist, einschließend wenigstens ein Monomer ausgewählt aus der Gruppe bestehend aus Vinylidenfluorid (VDF), Vinylfluorid (VF), Tetrafluorethylen (TFE), Hexafluorpropylen (HFP), Chlortrifluorethylen (CTFE), Trifluorethylen, Hexafluorisobutylen, Perfluorbutylethylen, Perfluor(methylvinylether) (PMVE), Perfluor(ethylvinylether) (PEVE), Perfluor(propylvinylether) (PPVE), Perfluor(hexylvinylether) (PHVE), Perfluor-2,2-dimethyl-1,3-dioxol (PDD) und Perfluor-2-methylen-4-methyl-1,3-dioxolan (PMD) in einer polymerisierten Form.

4. Rückseitiger Bogen nach Anspruch 1, wobei das wässrige Dispersionsbindemittel wenigstens eines ist, ausgewählt aus der Gruppe bestehend aus einem Polyurethanharz, einem Polyacrylharz, einem Polyharnstoffharz, einem Polyamidharz, einem Polyolefinharz, einem Polyvinylacetatharz, einem Polyetherharz, einem Alkydharz, einem UrethanAcrylat-Copolymer, einem Vinyl-Urethan-Copolymer, einem EthylenVinylalkohol-Copolymer, einem Silizium-Acryl-Urethan-Copolymer, einem Ethylen-Vinylacetat-Copolymer und einem Acryl-modifizierten Polyesterharz.

5. Rückseitiger Bogen nach Anspruch 1, wobei das wässrige Dispersionsbindemittel in einer Menge von 0,1 bis 50 Gewichtsteilen, in Bezug auf 100 Gewichtsteile des Fluorpolymers, eingeschlossen ist.

6. Rückseitiger Bogen nach Anspruch 1, wobei die wässrige Dispersionszusammensetzung ferner ein Vernetzungsmittel des wässrigen Dispersionsbindemittels einschließt.

7. Rückseitiger Bogen nach Anspruch 6, wobei das Vernetzungsmittel in einer Menge von 0,1 bis 50 Gewichtsteilen, in Bezug auf 100 Gewichtsteile des Fluorpolymers, eingeschlossen ist.

8. Rückseitiger Bogen nach Anspruch 1, wobei die Harzschicht auf einer oder beiden Oberflächen des Substrats gebildet ist.

9. Rückseitiger Bogen nach Anspruch 1, wobei das Substrat wenigstens ein Polymerfilm ist, ausgewählt aus der Gruppe bestehend aus einem Acrylfilm, einem Polyolefinfilm, einem Polyamidfilm, einem Polyurethanfilm und einem Polyesterfilm.

10. Rückseitiger Bogen nach Anspruch 1, wobei das Substrat eine Dicke von 50 bis 500 µm aufweist.

11. Verfahren zum Herstellen eines rückseitigen Bogens für ein Photovoltaikmodul, umfassend:
Bilden einer Harzschicht durch Beschichten einer wässrigen Dispersionszusammensetzung einschließend ein kristallines Fluorpolymer, ein Pigment, ein wässriges Dispersionsbindemittel und Wasser auf eine oder beide Oberflächen eines Substrats und Erwärmen in einem Ausrichtungsverfahren des Substrats.

12. Verfahren nach Anspruch 11, wobei das Ausrichtungsverfahren des Substrats ein biaxiales Ausrichtungsverfahren ist, bei dem das Substrat in eine Maschinenrichtung (MD) ausgerichtet wird, dann mit der wässrigen Dispersionszusammensetzung beschichtet wird und dann in einer Querrichtung (TD) ausgerichtet wird.

13. Verfahren nach Anspruch 11, wobei das Ausrichtungsverfahren des Substrats ein biaxiales Ausrichtungsverfahren ist, bei dem die wässrige Dispersionszusammensetzung auf dem Substrat beschichtet wird und dann das Substrat in Maschinen- und Querrichtungen (MD und TD) ausgerichtet wird.

14. Photovoltaikmodul, umfassend:
den rückseitigen Bogen für ein Photovoltaikmodul nach einem der Ansprüche 1 bis 10.

## Revendications

1. Feuille arrière pour un module de cellule photovoltaïque comprenant :
une couche de résine formée par revêtement d'une composition de dispersion aqueuse renfermant un fluoropolymère avec un alignement de cristaux, un pigment, un liant aqueux et de l'eau sur un substrat pendant l'orientation du substrat,
dans laquelle un pouvoir adhésif mesuré par un test de quadrillage réalisé selon l'ASTM D3002/D3359 après que la feuille arrière a été laissée dans un four maintenu à 2 atm, à 121 °C et à une humidité relative de 100 % pendant 75 heure est d'au moins 4B.

2. Feuille arrière selon la revendication 1, dans laquelle le fluoropolymère est un polymère cristallin ayant une cristallinité de 10 à 55 % et ayant une non fonctionnalité.

3. Feuille arrière selon la revendication 1, dans laquelle le fluoropolymère est un homopolymère, un copolymère ou un mélange de ceux-ci renfermant au moins un monomère sélectionné dans le groupe constitué de fluorure de vinylidène (VDF), de fluorure de vinyle (VF), de tétrafluoroéthylène (TFE), d'hexafluoropropylène (HFP), de chlorotrifluoroéthylène (CTFE), de trifluoroéthylène, d'hexafluoroisobutylène, de perfluorobutyléthylène, de perfluoro(méthylvinyléther) (PMVE), de perfluoro(éthylvinyléther) (PEVE), de perfluoro(propylvinyléther) (PPVE), de perfluoro(hexylvinyléther) (PHVE), de perfluoro-2,2-diméthyl-1,3-dioxole (PDD) et de perfluoro-2-méthylène-4-méthyl-1,3-dioxolane (PMD) sous une forme polymérisée.

4. Feuille arrière selon la revendication 1, dans laquelle le liant de dispersion aqueuse est au moins un liant sélectionné dans le groupe constitué d'une résine de polyuréthane, d'une résine polyacrylique, d'une résine de polyurée, d'une résine de polyamide, d'une résine de polyoléfine, d'une résine de polyvinylacétate, d'une résine de polyéther, d'une résine d'alkyde, d'un copolymère d'uréthane-acrylate, d'un copolymère de vinyl-uréthane, d'un copolymère d'éthylène-vinylalcool, d'un copolymère de silicium-acryle-uréthane, d'un copolymère d'éthylène-vinylacétate et d'une résine de polyester modifiée par l'acryle.

5. Feuille arrière selon la revendication 1, dans laquelle le liant de dispersion aqueuse est incorporé en une quantité de 0,1 à 50 parties en poids par rapport à 100 parties en poids du fluoropolymère.

6. Feuille arrière selon la revendication 1, dans laquelle la composition de dispersion aqueuse contient par ailleurs un agent réticulant du liant de dispersion aqueuse.

7. Feuille arrière selon la revendication 6, dans laquelle l'agent réticulant est incorporé en une quantité de 0,1 à 50 parties en poids par rapport à 100 parties en poids du fluoropolymère.

8. Feuille arrière selon la revendication 1, dans laquelle la couche de résine est formée sur une ou les deux surfaces du substrat.

9. Feuille arrière selon la revendication 1, dans laquelle le substrat est au moins un film polymère sélectionné dans le groupe constitué d'un film acrylique, d'un film polyoléfinique, d'un film de polyamide, d'un film de polyuréthane et d'un film de polyester.

10. Feuille arrière selon la revendication 1, dans laquelle le substrat a une épaisseur de 50 à 500 µm.

11. Procédé de fabrication d'une feuille arrière pour un module photovoltaïque comprenant les étapes consistant à :
former une couche de résine par revêtement d'une composition de dispersion aqueuse renfermant un fluoropolymère cristallin, un pigment, un liant de dispersion aqueuse et de l'eau sur une ou les deux surfaces d'un substrat et par chauffage dans le cadre d'un processus d'orientation du substrat.

12. Procédé selon la revendication 11, dans lequel le processus d'orientation du substrat est un processus d'orientation biaxiale, dans lequel le substrat est orienté dans la direction de la machine (MD), puis revêtu avec la composition de dispersion aqueuse, et ensuite orienté dans la direction transversale (TD).

13. Procédé selon la revendication 11, dans lequel le processus d'orientation du substrat est un processus d'orientation biaxiale, dans lequel la composition de dispersion aqueuse est revêtue sur le substrat, et le substrat est ensuite orienté dans des directions de la machine et transversale (MD et TD).

14. Module photovoltaïque comprenant :
la feuille arrière pour un module photovoltaïque selon l'une quelconque des revendications 1 à 10.
